# DEMANDE DE BREVET EUROPEEN

(11) **EP 0 881 514 A1**
(43) Date de publication de la demande: **02.12.1998**
(21) Numéro de dépôt: 97108694.7
(22) Date de dépôt: 30.05.1997
(51) Int. Cl.: G02B 27/09, H01S 3/00, H01S 3/091

(54) **Elément optique de couplage pour confiner spatialement et homogénéiser un faisceau ayant une grande ouverture**

(71) Demandeur: LASAG AG, CH-3600 Thun (CH)
(72) Inventeur: Leiglon, Eric, 1298 Celigny (CH); Sidler, Thomas, 1304 Cossonay (CH)
(74) Mandataire: Ravenel, Thierry Gérard Louis

(57) **Abrégé**

La présente invention concerne un élément optique (310) de couplage pour équiper une source lumineuse ayant une surface émettrice pour fournir un faisceau ayant une grande ouverture selon une première direction correspondant à une première dimension de la surface émettrice de ladite source lumineuse. Cet élément optique (310) est caractérisé en ce que sa face d'entrée (317) a une première dimension selon ladite première direction supérieure à ladite première dimension de ladite surface émettrice, et en ce que ladite première dimension de sa face d'entrée (317) est inférieure à la première dimension correspondante de sa face de sortie (318), lesdites premières dimensions desdites faces d'entrée et de sortie et la dimension entre ces deux faces étant ménagées de manière à réaliser une propagation dudit faisceau par réflexion totale interne sur ladite surface latérale, et à réduire la divergence de ce faisceau selon ladite première direction.

## Description

La présente invention concerne le domaine des coupleurs optiques et, plus particulièrement, des coupleurs optiques pour confiner spatialement et homogénéiser un faisceau ayant une grande ouverture selon une direction donnée.

Avec le développement croissant des micro-techniques basées sur des composants semiconducteurs fabriqués à faible coût, on utilise de plus en plus des sources lumineuses de petites dimensions telle que des diodes laser de puissance. Typiquement, la surface émettrice d'une telle diode laser a des première et seconde dimensions selon deux directions orthogonales, ces dimensions étant sensiblement différentes l'une de l'autre. A titre d'exemple, les première et seconde dimensions longitudinale et transversale d'une telle surface émettrice sont égales à 10 mm et 1 µm, respectivement.

Dans la suite de la présente description, lesdites première et seconde directions, ainsi que les dimensions respectives selon ces directions, seront appelées transversale et longitudinale, respectivement.

Un avantage de ces diodes réside dans le fait que leur rendement est supérieur à 50 %, et que la lumière qu'elles émettent est sensiblement monochromatique, contrairement à des lampes à décharge dont le rendement est compris entre 30 et 50 %, et qui émettent de la lumière blanche. Néanmoins, la puissance de ces diodes est limitée, actuellement inférieure à 20 W, ce qui conduit l'homme de l'art à réaliser des sources lumineuses formées de plusieurs diodes laser agencées de manière à obtenir une puissance élevée de faisceau émis.

Toutefois, le faisceau issu d'une telle diode laser présente des problèmes optiques.

De façon générale, on définit l'ouverture d'un faisceau selon une direction donnée comme l'angle pour lequel l'intensité de ce faisceau selon cette direction est égale à sa valeur maximale divisée par e², l'origine des angles étant prise pour ladite valeur maximale. Et, dans la suite de la présente description, une ouverture de faisceau est dite "grande" si elle est supérieure à 30 °.

Dans le cas d'une diode laser telle que décrite ci-dessus, le faisceau issu de la surface émettrice de cette diode a des première et seconde ouvertures selon lesdites directions transversale et longitudinale, ces ouvertures étant sensiblement différentes l'une de l'autre. A titre d'exemple, pour une diode laser dont les dimensions longitudinale et transversale de la surface émettrice sont égales à 10 mm et 1 µm, respectivement, les ouvertures longitudinale et transversale sont d'environ 10 ° et 40 °, respectivement. Ainsi, le faisceau issu d'une diode laser présente des problèmes de confinement spatial.

Par ailleurs, le faisceau issu d'une telle diode laser présente également des problèmes d'homogénéité, comme cela est expliqué ci-après.

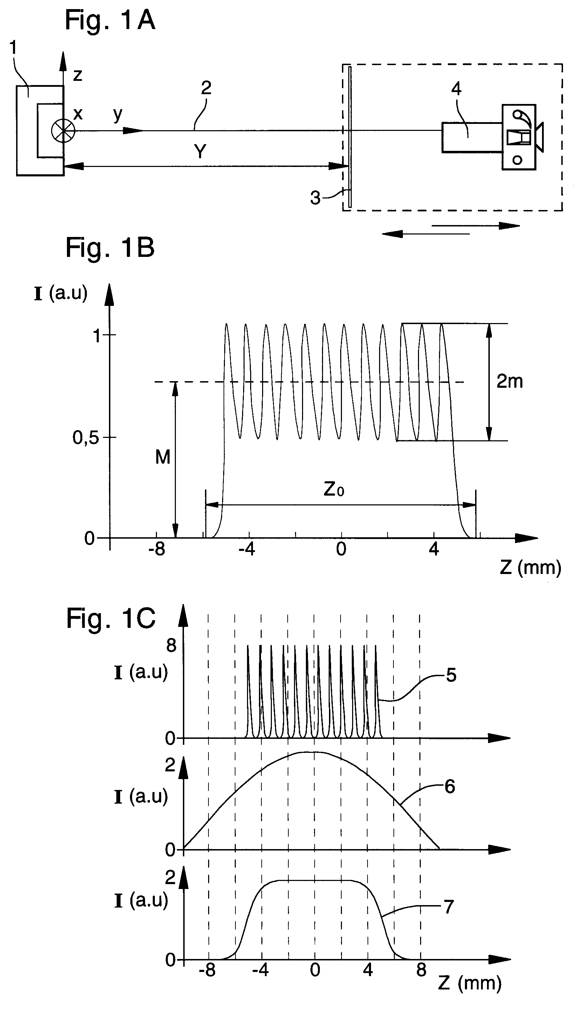

A titre illustratif uniquement, la figure 1A représente une diode laser 1 ayant une surface émettrice comprise dans un plan défini par un axe x et un axe z. Cette surface fournit un faisceau 2 qui se propage selon l'axe y.

Dans cette figure, comme dans la suite de la présente description, les axes x et z correspondent, respectivement, aux directions transversale et longitudinale de ladite surface émettrice, tel que décrit ci-dessus. Et l'axe y correspond à la direction de propagation du faisceau émis par cette surface.

L'intensité I de ce faisceau est mesurée sur un plan de mesure 3 disposé à une distance Y de la diode laser 1, et un système d'acquisition 4 permet d'extraire la répartition de l'intensité I mesurée. La référence Z désigne la distance entre l'axe y et un point du plan de mesure 3. La figure 1B représente de façon schématique un telle répartition de l'intensité I en fonction de la distance Z, dans le cas où la diode laser 1 a une surface émettrice dont les dimensions longitudinale et transversale sont égales à 10 mm et 1 µm, respectivement. Comme le représente la figure 1B, la référence M désigne la valeur moyenne de l'intensité I, la référence Zₒ désigne la plage spatiale dans laquelle l'intensité I est non nulle, la référence 2m désigne la profondeur de modulation, c'est-à-dire la différence entre la moyenne des maxima et celle des minima de la modulation de l'intensité I sur la plage spatiale dans laquelle l'intensité fluctue autour de la moyenne M, et la référence l_{d} désigne la dimension longitudinale de la diode laser 1.

A partir de la répartition représentée en figure 1B, on peut définir l'homogénéité du faisceau 2 par un premier critère désigné CH, ce critère étant égal à 2 m/M. On peut également définir le confinement spatial du faisceau 2 par un second critère désigné CC, ce critère étant égal à Zₒ/l_{d}.

Toutefois ces deux critères CH et CC sont antagonistes. En effet, quand on diminue la distance Y, c'est-à-dire la distance entre la diode laser 1 et le plan de mesure 3, le confinement du faisceau 2 s'améliore, et le critère CC s'approche de 1. Par contre, quand on augmente la distance Y, l'homogénéisation du faisceau 2 s'améliore, et le critère CH s'approche de 0. Par conséquent, il existe une situation optimale qui correspond à une valeur déterminée de la distance Y.

A titre illustratif uniquement, la figure 1C représente trois répartitions 5, 6 et 7 de l'intensité I pour trois valeurs distinctes de la distance Y, dans le cas où la diode laser 1 a une surface émettrice dont les dimensions longitudinale et transversale sont égales à 10 mm et 1 µm, respectivement. La répartition 5 correspond au cas où l'intensité I n'est pas homogène, et la répartition 6 correspond au cas où l'intensité I n'est pas confinée spatialement. La répartition 7 correspond au cas optimum par rapport aux critères CH et CC, où l'énergie est distribuée régulièrement sur une longueur de 14 mm, selon la direction longitudinale.

Dans le cas typique d'un pompage optique transversal d'un milieu laser, l'intensité du faisceau de pompage doit être de préférence homogène, confinée spatialement, et centrée sur la section de ce milieu. Autrement dit, il est souhaitable que le faisceau de pompage n'ait pas de fort gradient d'énergie sur l'axe laser. En effet, la qualité et la stabilité du faisceau laser qui émerge d'un tel laser dépendent fortement de l'homogénéité de l'énergie de pompage déposée dans le milieu laser. En outre, l'effet laser ne se produit qu'au-delà d'un certain seuil de puissance de pompage, ce qui nécessite une intensité de pompage maximale dans le milieu. L'homme de l'art notera alors qu'il est difficile de concentrer la lumière d'un tel faisceau sans pertes de puissance notables.

Une solution à ces problèmes optiques consiste à rapprocher la diode laser du milieu laser à pomper. Toutefois, la proximité de cette diode provoque un pompage non homogène le long de l'axe optique du milieu laser, de telle sorte qu'il se produit localement des échauffements du milieu laser, ce qui nécessite l'utilisation d'un système supplémentaire pour refroidir le milieu. L'agencement d'un tel système tend à encombrer l'environnement du laser, et à compliquer les réglages optiques du laser, ce qui va à l'encontre des préoccupations habituelles relatives à la réalisation d'un laser stable et facile à mettre en oeuvre.

Une autre solution classiquement utilisée pour remédier aux problèmes susmentionnés consiste à utiliser un élément optique supplémentaire disposé entre la diode laser et le milieu laser à pomper, cet élément optique étant destiné à conduire le faisceau de la diode laser au milieu laser.

On a ainsi utilisé des éléments optiques de grande ouverture telle qu'une ou plusieurs lentilles cylindriques. Toutefois, de tels éléments sont difficiles à fabriquer et à manipuler, ce qui va à l'encontre des préoccupations habituelles de réalisation d'un laser.

On a aussi utilisé un élément optique de couplage conjointement avec une lentille collimatrice, ladite lentille étant disposée entre la diode laser et l'élément optique, cet ensemble étant agencé de manière à réaliser la collimation du faisceau issu de la diode laser, et à fournir un faisceau de pompage ayant une intensité homogène. A titre illustratif, le brevet WO 93/2281 décrit, en se référant à la figure 2 de la présente invention, un dispositif optique 10 de couplage destiné à équiper un milieu laser 11, ce dispositif optique 10 comprenant un coupleur optique 12 destiné à concentrer le faisceau issu d'une diode laser 13. Des moyens 15 de réglage précis sont agencés pour faciliter l'alignement du coupleur optique 12, ce coupleur étant positionné de manière à réaliser le couplage optique de la diode laser 13 avec le milieu laser 11. De préférence, le coupleur optique 12 a une forme de révolution ayant une face d'entrée 17 et une face de sortie 18, et sont formés dans un matériau diélectrique cristallin ayant un indice de réfraction élevé, tel que du saphir. Le dispositif optique 10 comprend en outre une lentille collimatrice 16 agencée sur la face d'entrée 17 du coupleur optique 12, de manière à réaliser la collimation du faisceau issu de la diode laser 13.

Un inconvénient d'un tel coupleur optique réside dans le fait qu'il est nécessaire d'utiliser une lentille pour réaliser la collimation du faisceau non confiné issu de la diode laser, de sorte que ce faisceau converge à l'entrée de ce coupleur pour éviter un retour de faisceau.

Un autre inconvénient d'un tel coupleur optique sur la face d'entrée duquel est montée une lentille collimatrice réside dans la sensibilité de ce montage au désalignement. Au-delà des problèmes liés à l'ajustement ou à la stabilité mécanique de ce montage, la simple déformation de la zone d'émission, sous l'effet de la charge thermique lors du fonctionnement de la diode se traduit par un déplacement (typiquement de l'ordre de quelques micromètres) suffisant pour réduire l'efficacité de transmission de ces systèmes.

Un objet de la présente invention est de prévoir un élément optique de couplage pour confiner spatialement selon au moins une première direction un faisceau ayant une grande ouverture selon cette direction, cet élément optique étant agencé de manière à pallier les problèmes et les inconvénients susmentionnés.

Un autre objet de la présente invention est de prévoir un tel élément optique pour homogénéiser un faisceau ayant une grande ouverture selon ladite première direction.

Un autre objet de la présente invention est de prévoir un tel élément répondant aux préoccupations habituelles d'une application optique non critique, relatives à un coût de réalisation, et à de larges tolérances de construction et de montage.

Un autre objet de la présente invention est de prévoir un dispositif optique comprenant une source lumineuse dont la surface émettrice a une première dimension comprise entre 1 µm et 1,5 mm, ce dispositif optique étant agencé de manière à fournir un faisceau confiné spatialement selon ladite première direction, ainsi qu'homogène.

Un autre objet de la présente invention est de prévoir un dispositif optique de pompage pour réaliser le couplage optique d'une diode laser avec un milieu laser, de manière à réaliser un pompage optique transversal de ce milieu.

Ces objets, ainsi que d'autres, sont atteints par l'élément optique de couplage selon la revendication 1, le dispositif optique selon la revendication 10, et le dispositif de pompage optique selon la revendication 11.

Un avantage de la face d'entrée de l'élément optique selon la présente invention est de permettre une transmission maximale de la lumière issue de ladite source lumineuse, à cet élément.

Un avantage des faces d'entrée et de sortie, ainsi que de la dimension entre ces deux faces, de l'élément optique selon la présente invention est de pouvoir réaliser une réduction de la divergence du faisceau issu de ladite source lumineuse.

Grâce à d'autres caractéristiques, un avantage du décalage angulaire entre les deux côtés de la section trapézoïdale de l'élément optique selon la présente invention est de permettre une propagation du faisceau issu de ladite source lumineuse sur ladite surface latérale de cet élément optique.

Grâce à d'autres caractéristiques, un avantage de la couche antireflet de l'élément optique selon la présente invention est de rendre minimales les pertes de puissance lors de la réflexion du faisceau sur les faces d'entrée et de sortie de cet élément.

Grâce à d'autres caractéristiques, un avantage de l'agencement du dispositif optique selon la présente invention est de permettre la fourniture d'un faisceau confiné spatialement et homogène.

Grâce à d'autres caractéristiques, un avantage de l'agencement du dispositif de pompage optique selon la présente invention est de pouvoir coupler optiquement ladite diode laser avec ledit milieu laser pour réaliser un pompage optique transversal dudit milieu.

Ces objets, caractéristiques et avantages, ainsi que d'autres, de la présente invention apparaîtront plus clairement à la lecture de la description détaillée de quelques modes de réalisation préférés de l'invention, et de leurs mises en oeuvre, donnés à titre d'exemple uniquement, en relation avec les figures jointes, parmi lesquelles :
- la figure 1A déjà citée représente un montage optique classique d'une diode laser utilisée en tant que source émettrice;
- la figure 1B déjà citée représente de façon schématique une répartition d'intensité du faisceau issu de la diode laser du montage de la figure 1A;
- la figure 1C déjà citée représente de façon schématique trois profils d'intensité différents relatifs au montage de la figure 1A;
- la figure 2 déjà citée représente le montage d'un milieu laser équipé d'un dispositif optique de pompage transversal selon l'art antérieur;
- les figures 3A et 3B représentent des premier et second modes de réalisation préférés d'un élément optique selon la présente invention;
- la figure 4 représente un dispositif optique de couplage comprenant l'élément optique de la figure 3B, ce dispositif étant destiné à fournir un faisceau confiné spatialement et homogène;
- la figure 5 représente deux courbes permettant la détermination de l'ouverture du faisceau sortant de l'élément optique dans le dispositif de la figure 4;
- les figures 6A et 6B représentent les montages permettant la mesure des tolérances aux désalignements pour l'élément optique dans le dispositif de la figure 4;
- les figures 7A et 7B représentent les courbes permettant la détermination des tolérances aux désalignements, à partir de mesures effectuées avec les montages des figures 6A et 6B, respectivement; et
- la figure 8 représente un dispositif optique de pompage transversal comprenant l'élément optique de la figure 3B, ce dispositif étant destiné à coupler optiquement une diode laser avec un milieu laser.

De nombreuses simulations numériques et expériences ont permis à la demanderesse de la présente invention de dimensionner un élément optique de couplage destiné à équiper une source lumineuse ayant une surface émettrice pour fournir un faisceau ayant une grande ouverture selon une première direction correspondant à une première dimension de la surface émettrice de ladite source lumineuse.

Dans la suite de la présente description, comme cela a été défini en relation avec la figure 1A, ladite première direction est appelée également direction transversale, et la seconde direction de ladite surface émettrice est appelée également direction longitudinale. De même, toutes les dimensions relatives à ces directions respectives seront appelées dimensions transversales ou longitudinales.

Cet élément optique comprend une face d'entrée, une face de sortie parallèle à la face d'entrée, et une surface latérale joignant la face d'entrée à la face de sortie, cet élément optique étant destiné à recevoir en entrée ledit faisceau provenant de ladite source lumineuse.

En outre, ladite face d'entrée a une dimension transversale supérieure à la dimension transversale de ladite surface émettrice, de manière à permettre un réglage aisé et stable de cet élément optique pourvu de ladite source lumineuse. La dimension transversale de ladite face d'entrée est inférieure à la dimension transversale de ladite face de sortie, lesdites dimensions transversales de ladite face d'entrée et de ladite face de sortie et la dimension entre ces deux faces étant ménagées de manière à réaliser une propagation dudit faisceau par réflexion totale interne, et à réduire la divergence de ce faisceau selon la direction transversale.

D'autres simulations numériques et expériences menées par la demanderesse de la présente invention ont aussi permis de définir la dimension transversale de la face d'entrée d'un tel élément optique. A titre d'exemple, si on utilise une source lumineuse ayant une surface émettrice dont la dimension transversale est comprise entre 1 µm et 1,5 mm, sa dimension longitudinale étant égale à 10 mm, la dimension transversale de la face d'entrée dudit élément optique est comprise de préférence entre 100 µm et 2 mm, respectivement, et sa dimension longitudinale est supérieure ou égale à celle de ladite surface émettrice.

Des simulations numériques et expériences supplémentaires ont également conduit au fait que la hauteur des pics de modulation tel que définis en figure 1B diminue quand la dimension entre la face d'entrée et la face de sortie d'un tel élément optique augmente.

L'élément optique selon la présente invention peut être formé de préférence dans un verre ayant les caractéristiques qui suivent. Ce verre doit avoir un indice de réfraction homogène, et sensiblement égal à 1,5. En outre, il va de soi que ce verre doit être transparent pour ne pas absorber la lumière qui le traverse.

A titre de variante, l'élément optique selon la présente invention peut comprendre en outre une couche antireflet que l'on dépose sur lesdites faces d'entrée et de sortie de cet élément, de manière à rendre minimales les pertes de puissance lors des réflexions du faisceau sur ces faces.

L'homme de l'art note que l'on peut ménager une surface plane, cylindrique ou parabolique en tant que surface latérale de l'élément optique selon la présente invention. Toutefois, la demanderesse de la présente invention a observé que la surface plane peut être avantageusement choisie en tant que surface latérale, comme cela va être expliqué de façon plus détaillée ci-après.

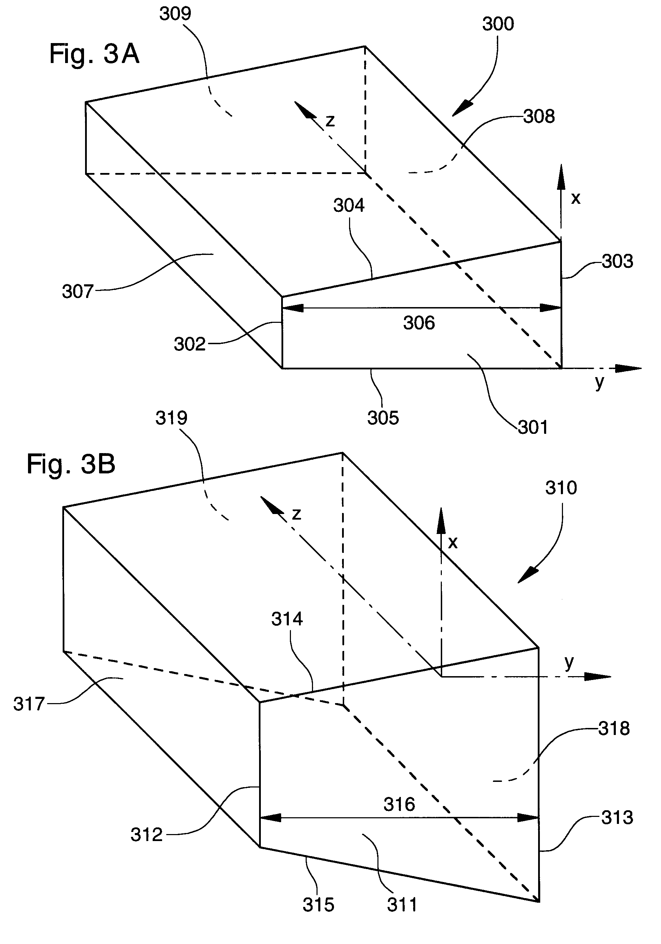

La figure 3A représente un premier mode de réalisation préféré d'un élément optique 300 selon la présente invention.

L'élément optique 300 a la forme générale d'un prisme droit ayant une section trapézoïdale 301 qui comprend des petite et grande bases parallèles, désignées 302 et 303 respectivement, et deux côtés 304 et 305 formant un décalage angulaire entre eux. La hauteur 306 de la section trapézoïdale 301 correspond à la dimension entre la face d'entrée 307 et la face de sortie 308 de l'élément optique 300, et la petite base 302 et la grande bases 303 correspondent aux dimensions transversales de ces faces 307 et 308, respectivement.

Puisque la petite base 302 correspond à la dimension transversale de ladite face d'entrée 307, la petite base 302 est comprise entre 100 µm et 2 mm, si l'élément optique 300 est destiné à équiper une source lumineuse dont la surface émettrice a une dimension transversale comprise entre 1 µm et 1,5 mm, et une dimension longitudinale égale à 10 mm.

L'homme de l'art note que la hauteur 306 dépend des propriétés angulaires d'une source lumineuse (non représentée en figure 3A) utilisée pour éclairer l'élément optique 300, et de l'indice de réfraction du verre formant cet élément. Selon des simulations numériques et expériences menées par la demanderesse de la présente invention, la hauteur 306 est de préférence inférieure à 20 mm. Quand une diode laser ayant une surface émettrice dont les dimensions longitudinale et transversale sont égales à 10 mm et 1 µm, respectivement, est utilisée en tant que source lumineuse, et que l'élément optique 300 est formé dans un verre ayant un indice de réfraction égal à 1,5, la situation est optimale, par rapport aux critères CH et CC, quand la hauteur 306 est égale à 6 mm.

La petite base 302 et la hauteur 306 ayant déjà été choisies, comme cela est décrit ci-dessus, la grande base 303 de la section trapézoïdale 301 est choisie de telle sorte que ledit décalage angulaire de cette section est compris entre 5 et 40 °, de manière à garantir la réflexion totale interne du faisceau sur la surface délimitée par des faces désignées 307, 301, 308 et 309.

On peut ainsi dimensionner entièrement l'élément optique 300 à partir de la taille de la source lumineuse et, plus précisément, à partir de la dimension transversale de cette source.

La figure 3B représente un second mode de réalisation préféré d'un élément optique 310 selon la présente invention, cet élément comprenant les plans xy et yz comme plans de symétrie, les axes x, y et z étant ceux définis en relation avec la figure 1A.

L'élément optique 310 a la forme générale d'un prisme droit ayant une section trapézoïdale 311 qui comprend des petite et grande bases parallèles, désignées 312 et 313 respectivement, et deux côtés 314 et 315 formant un décalage angulaire entre eux. La hauteur 316 de la section trapézoïdale 311 correspond à la dimension entre la face d'entrée 317 et la face de sortie 318 de l'élément optique 310, et la petite base 312 et la grande base 313 correspondent aux dimensions transversales de ces faces 317 et 318, respectivement.

Puisque la petite base 312 correspond à la dimension transversale de ladite face d'entrée 317, la petite base 312 est comprise entre 100 µm et 2 mm, si l'élément optique 310 est destiné à équiper une source lumineuse dont la surface émettrice a une dimension transversale comprise entre 1 µm et 1,5 mm, et une dimension longitudinale égale à 10 mm.

L'homme de l'art note que la hauteur 316 dépend des propriétés angulaires d'une source lumineuse (non représentée en figure 3B) utilisée pour éclairer l'élément optique 310, et de l'indice de réfraction du verre formant cet élément. Selon des simulations numériques et expériences menées par la demanderesse de la présente invention, la hauteur 316 est de préférence inférieure à 20 mm. Quand on utilise en tant que source lumineuse une diode laser ayant une surface émettrice dont les dimensions longitudinale et transversale sont égales à 10 mm et 1 µm, respectivement, et que l'élément optique 310 est formé dans un verre ayant un indice de réfraction égal à 1,5, la situation est optimale, par rapport aux critères CH et CC, quand la hauteur 316 est égale à 6 mm.

La petite base 312 et la hauteur 316 ayant déjà été choisies, comme cela est décrit ci-dessus, la grande base 313 de la section trapézoïdale 311 est choisie de telle sorte que ledit décalage angulaire de cette section est compris entre 5 et 40 °, de manière à garantir la réflexion totale interne du faisceau sur la surface délimitée par des faces désignées 317, 311, 318 et 319.

L'élément optique 310 ainsi dimensionné a avantageusement une efficacité supérieure à 95 %, l'efficacité étant définie comme le rapport entre la puissance incidente et la puissance émergente, pour un dispositif donné. Par contre, les coupleurs classiques tels que décrits dans le brevet WO 93/2281, pourvus d'une lentille collimatrice, n'ont qu'une efficacité comprise entre 80 et 85 %.

En se référant au critère CH relatif à l'homogénéisation de faisceau, comme cela a déjà été défini, l'élément optique 310 tel que dimensionné ci-dessus dans le cas optimal a avantageusement un critère CH compris entre 0 et 0,2. Par ailleurs, les coupleurs classiques tels que décrits dans le brevet WO 93/2281, et pourvus d'une lentille collimatrice, ont un critère CH de l'ordre de 2.

En se référant au critère CC relatif au confinement spatial de faisceau, comme cela a déjà été défini, l'élément optique 310 tel que dimensionné ci-dessus a un critère CC sensiblement égal à 1,4. Par ailleurs, les coupleurs classiques tels que décrits dans le brevet WO 93/2281, et pourvus d'une lentille collimatrice, ont un critère CC de l'ordre de 1,5.

L'élément optique 310 tel que décrit ci-dessus en relation avec la figure 3B peut être mis en oeuvre dans un dispositif optique pour fournir un faisceau confiné spatialement et homogène.

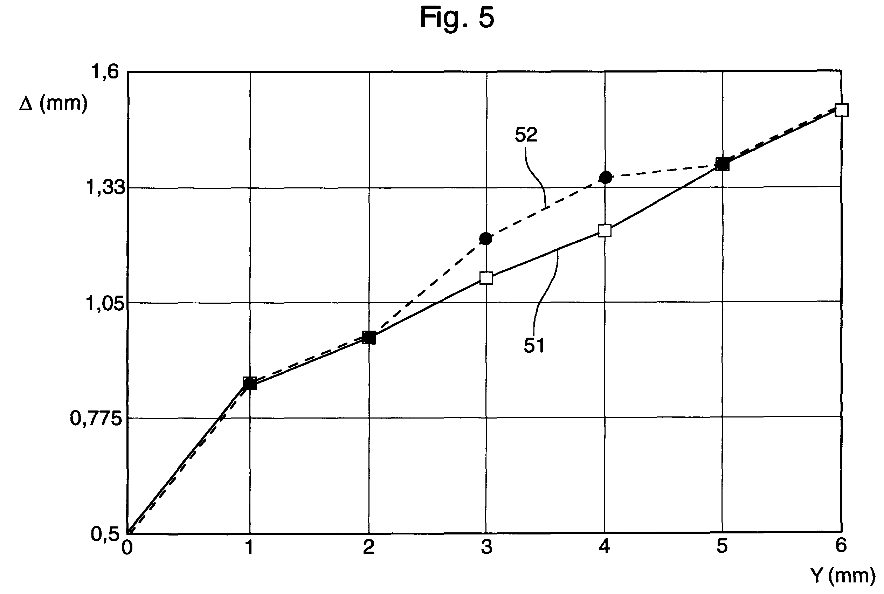

La figure 4 représente un tel dispositif optique comprenant une diode laser 40 utilisée en tant que source lumineuse ayant une surface émettrice comprise dans un plan défini par un axe x et un axe z. Cette surface fournit un faisceau se propageant selon l'axe y, et ce faisceau a une grande ouverture selon une première direction (ici l'axe x) qui correspond à une première dimension de ladite surface émettrice. La face d'entrée 317 de l'élément optique 310 est disposée au voisinage de ladite surface émettrice de la diode laser 40. Dans ce cas, l'intensité du faisceau sortant de l'élément optique 310 est sensiblement constante sur une plage spatiale d'environ 14 mm. Autrement dit, l'élément optique 310 a réalisé une homogénéisation de l'intensité du faisceau selon ladite direction longitudinale.

Ensuite, un écran translucide ou plan de mesure 41 est déplacé le long de l'axe y, et une image de cet écran est réalisée par un système de détection 42. On peut ainsi mesurer la répartition d'intensité du faisceau qui émerge de l'élément optique 310, par la face de sortie 318, en fonction d'une distance désignée Y entre cet élément et le plan de mesure 41. On peut alors déterminer la dimension désignée Δ selon la direction transversale (ici l'axe x) pour laquelle l'intensité de ce faisceau selon cette direction est égale à sa valeur maximale divisée par e², l'origine de cet axe correspondant au milieu de la face de sortie 318, comme le représente la figure 4. Les mêmes conditions sont également simulées, et les dimensions Δ issues de l'expérience et de simulations numériques sont représentées en figure 5 par des courbes 51 et 52, respectivement.

On peut extraire de ces résultats la valeur de la divergence du faisceau qui émerge de l'élément optique 310, autrement dit l'ouverture transversale du faisceau sortant. On obtient ainsi d'après les courbes 51 et 52 une ouverture transversale de faisceau sortant égale à 10,7 ° et 10,1 °, respectivement.

Par conséquent, si une diode laser est pourvue de l'élément optique 310 tel que dimensionné ci-dessus en relation avec la surface émettrice de cette diode, les ouvertures transversale et longitudinale du faisceau incident issu de la diode laser sont égales à 40 ° et 10 °, respectivement, et l'ouverture transversale du faisceau qui émerge de cet élément est égale à 10 °, l'ouverture longitudinale du faisceau incident n'étant pas modifiée lors de la traversée dans ledit élément. Autrement dit, l'élément optique 310 réalise un confinement spatial du faisceau selon ladite direction transversale, et fournit un faisceau sortant centré et légèrement divergent.

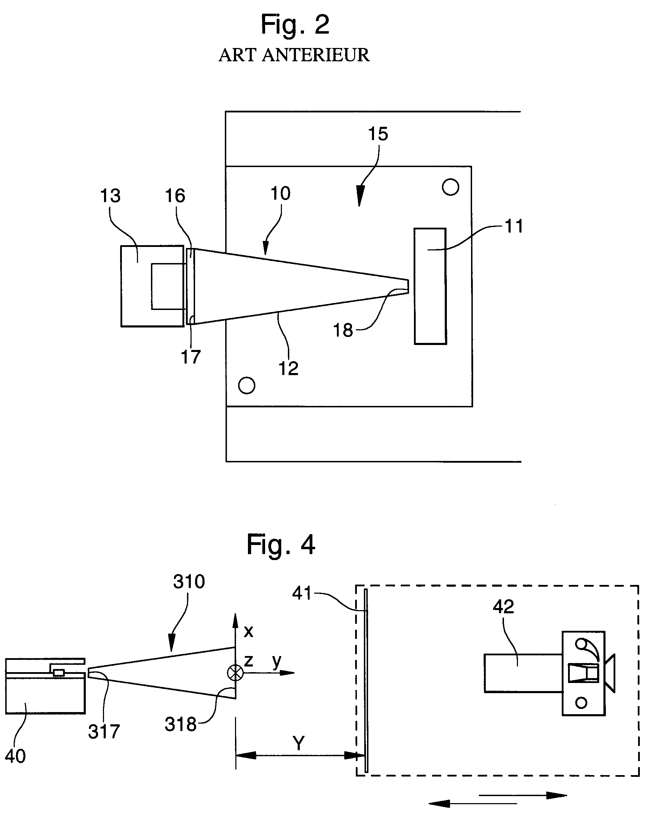

L'homme de l'art note que l'élément optique 310 réalise aussi une collimation du faisceau sans avoir recours à une lentille collimatrice contrairement au montage classique décrit en relation avec la figure 2.

En outre, on peut disposer avantageusement une lentille sphérique sur la face de sortie 318 de l'élément optique 310 pour focaliser le faisceau qui émerge de cet élément et, puisque ce faisceau est alors confiné spatialement, on peut ainsi prévoir avantageusement une lentille sphérique ayant une faible ouverture, typiquement d'environ 20 °.

Par ailleurs, la demanderesse de la présente invention a mesuré des tolérances de désalignement relatives à l'élément optique 310 dimensionné dans le cas optimal, comme cela est décrit ci-dessus en relation avec la figure 3B.

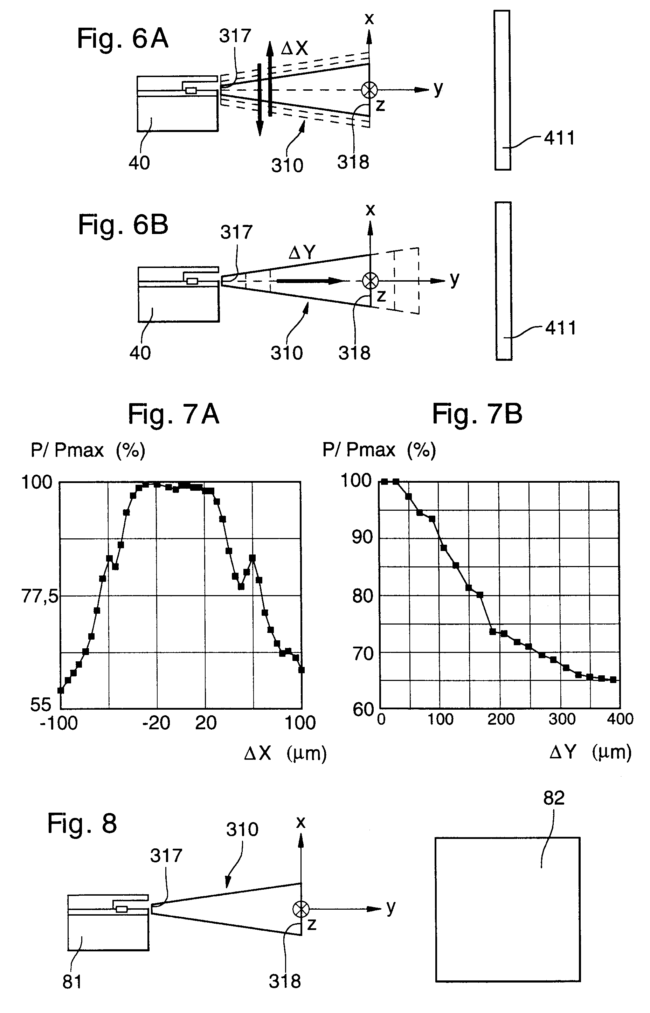

Les figures 6A et 6B représentent les montages permettant de mesurer ces tolérances selon l'axe x et l'axe y, respectivement, ces axes étant ceux définis en relation avec la figure 4. Ces deux montages sont sensiblement identiques au montage de la figure 4. Ainsi, la face d'entrée 317 de l'élément optique 310 est agencée au voisinage de la surface émettrice d'une diode laser 40 utilisée en tant que source lumineuse. Un système de détection 411 est placé sur l'axe y, à une distance fixe de la diode laser 40. La puissance désignée P du faisceau sortant de l'élément optique 310 est alors mesurée pour un déplacement de cet élément le long de l'axe x ou y, ce déplacement étant désigné ΔX ou ΔY, respectivement. La référence Pmax désignera la puissance maximale mesurée sur l'ensemble du déplacement le long de l'axe x ou y.

La figure 7A illustre le rapport P/Pmax en fonction du déplacement ΔX, et la figure 7B illustre le rapport P/Pmax en fonction du déplacement ΔY.

La tolérance de désalignement de l'élément optique 310 selon l'axe x, ou y, est alors définie comme le déplacement respectif ΔX, ou ΔY, correspondant à la puissance P égale à 98 % de la puissance Pmax.

Il ressort alors des figures 7A et 7B que les tolérances de désalignement de l'élément optique 310 selon l'axe x et l'axe y sont de l'ordre de 10 µm et 45 µm, respectivement. Ainsi, dans le cas optimal où la face d'entrée 317 de l'élément optique 310 a une dimension transversale égale à 100 µm, et si la position transversale de cet élément varie de 45 µm par rapport à sa valeur nominale, l'élément optique 310 assure un couplage efficace.

Il va de soi que l'élément optique 310 susceptible d'être déplacé tout en fournissant une puissance de faisceau sensiblement constante est particulièrement avantageux, puisque cet élément peut être manipulé avec une large tolérance de montage.

En outre, la demanderesse de la présente invention a observé que la tolérance de désalignement selon la direction transversale dépend avantageusement de la dimension transversale de la face d'entrée 317 de l'élément optique 310.

Par ailleurs, la demanderesse de la présente invention a observé que l'élément optique 310 selon la présente invention réalise également une homogénéisation selon la direction transversale de l'intensité du faisceau sortant de cet élément, dans le cas où cet élément équipe une source lumineuse ayant plusieurs zones d'émission de faisceau.

L'élément optique 310 selon la présente invention peut également être mis en oeuvre dans un dispositif de pompage optique pour équiper un milieu laser 82.

La figure 8 représente un tel dispositif de pompage comprenant une diode laser 81 utilisée en tant que source lumineuse ayant une surface émettrice comprise dans un plan défini par un axe x et un axe z. Cette surface fournit un faisceau se propageant selon l'axe y, et ayant une grande ouverture selon une première direction (ici l'axe x) qui correspond à une première dimension de ladite surface émettrice. La face d'entrée 317 de l'élément optique 310 est agencée au voisinage de ladite surface émettrice de la diode laser 81, et le dispositif optique ainsi agencé permet de coupler optiquement la diode laser 81 avec le milieu laser 82 pour réaliser un pompage optique transversal de ce milieu.

L'homme de l'art note que, dans un tel dispositif optique de pompage transversal, le coefficient d'absorption du cristal formant le milieu laser 82 a un effet sur la répartition de puissance de pompage dans ce milieu et, plus particulièrement, sur le pourcentage de puissance de pompage se trouvant dans le mode fondamental du milieu laser 82, le mode fondamental d'un milieu laser étant le mode pour lequel la brillance du faisceau émis par ce milieu est maximale. A titre d'exemple, des simulations numériques menées par la demanderesse de la présente invention ont permis de calculer le pourcentage de puissance de pompage se trouvant dans le mode fondamental du milieu laser 82, en fonction du coefficient d'absorption du cristal formant ce milieu. Les résultats ont été reportés dans la table 1 qui suit.

**TABLE 1**

| coefficient d'absorption (cm⁻¹) | pourcentage de puissance de pompage |
|---|---|
| 0,1 | 40,0 |
| 1,0 | 59,6 |
| 2,0 | 59,0 |
| 3,0 | 57,6 |
| 5,0 | 53,3 |
| 9,0 | 41,2 |

La situation est optimale quand le coefficient d'absorption du cristal formant le milieu laser 82 est d'environ 1 cm⁻¹. Un changement dans l'absorption peut être réalisé en modifiant la longueur d'onde d'émission de la diode laser 81 par le réglage de sa température, par exemple.

Les simulations numériques menées par la demanderesse de la présente invention ont également abouti au fait que la situation optimale relative au coefficient d'absorption du cristal formant le milieu laser 82 est indépendante de la forme de l'élément optique 310.

Il va de soi pour l'homme de l'art que la description détaillée ci-dessus peut subir diverses modifications sans sortir du cadre de la présente invention. A titre d'exemple, l'élément optique selon la présente invention peut être prévu pour équiper une source lumineuse ayant sa longueur d'onde d'émission dans le domaine des rayonnements infrarouges ou ultraviolets.

## Revendications

1. Elément optique (310) de couplage destiné à équiper une source lumineuse ayant une surface émettrice pour fournir un faisceau ayant une grande ouverture selon une première direction correspondant à une première dimension de ladite surface émettrice de ladite source lumineuse, cet élément comprenant une face d'entrée (317), une face de sortie (318) parallèle à ladite face d'entrée (317), et une surface latérale joignant ladite face d'entrée (317) à ladite face de sortie (318), cet élément étant caractérisé en ce que :
- ladite face d'entrée (317) a une première dimension selon ladite première direction supérieure à ladite première dimension de ladite surface émettrice; et en ce que
- ladite première dimension de ladite face d'entrée (317) est inférieure à la première dimension correspondante de ladite face de sortie (318), lesdites premières dimensions de ladite face d'entrée (317) et de ladite face de sortie (318) et la dimension entre ces deux faces étant ménagées de manière à réaliser une propagation dudit faisceau par réflexion totale interne, et à réduire la divergence de ce faisceau selon ladite première direction.

2. Elément optique (310) selon la revendication 1, caractérisé en ce qu'il a la forme générale d'un prisme droit ayant une section trapézoïdale (311) qui comprend une petite base (312) et une grande base (313) parallèle à ladite petite base (312), et deux côtés (314; 315) formant un décalage angulaire entre eux, en ce que la hauteur (316) de ladite section trapézoïdale (311) correspond à ladite dimension entre ladite face d'entrée (317) et ladite face de sortie (318), et en ce que ladite petite base (312) et ladite grande base (313) de ladite section trapézoïdale (311) correspondent auxdites premières dimensions de ladite face d'entrée (317) et de ladite face de sortie (318), respectivement.

3. Elément optique (310) selon la revendication 2, caractérisé en ce que ladite hauteur (316) de ladite section trapézoïdale (311) est inférieure à 20 mm.

4. Elément optique (310) selon la revendication 3, caractérisé en ce que ladite petite base (312) de ladite section trapézoïdale (311) est comprise entre 100 µm et 2 mm, pour ladite première dimension de ladite surface émettrice comprise entre 1 µm et 1,5 mm, respectivement.

5. Elément optique (310) selon la revendication 4, caractérisé en ce que ladite grande base (313) de ladite section trapézoïdale (311) est choisie de telle sorte que ledit décalage angulaire entre lesdits côtés (314; 315) de ladite section trapézoïdale (311) est compris entre 5 et 40 °.

6. Elément optique (310) selon l'une des revendications précédentes, caractérisé en ce que ladite face d'entrée (317) et ladite face de sortie (318) ont chacune une seconde dimension supérieure ou égale à la seconde dimension de ladite surface émettrice.

7. Elément optique (310) selon l'une des revendications précédentes, caractérisé en ce qu'il est formé dans un verre ayant un indice de réfraction homogène, et sensiblement égal à 1,5.

8. Elément optique (310) selon l'une quelconque des revendications précédentes, caractérisé en ce qu'il comprend en outre une couche antireflet déposée sur ladite face d'entrée (317) et ladite face de sortie (318), de manière à rendre minimales les pertes de puissance lors de réflexions du faisceau sur ces faces.

9. Dispositif optique pour fournir un faisceau confiné spatialement et homogène, ce dispositif comprenant une source lumineuse ayant une surface émettrice pour fournir un faisceau ayant une grande ouverture selon une première direction qui correspond à une première dimension de ladite surface émettrice, et un élément optique selon l'une quelconque des revendications précédentes équipant ladite source lumineuse.

10. Dispositif de pompage optique pour équiper un milieu laser, ce dispositif comprenant une source lumineuse ayant une surface émettrice pour fournir un faisceau ayant une grande ouverture selon une première direction qui correspond à une première dimension de ladite surface émettrice, et un élément optique selon l'une des revendications 1 à 8 équipant ladite source lumineuse, ce dispositif étant agencé de manière à coupler optiquement ladite source lumineuse avec ledit milieu laser pour réaliser un pompage optique transversal de ce milieu.
